(19) Europäisches Patentamt
European Patent Office
Office européen des brevets

(11) Publication number: 0 434 087 A2

# (12) EUROPEAN PATENT APPLICATION

(21) Application number: **90125127.2**

(22) Date of filing: **21.12.90**

(51) Int. Cl.$^5$: **C08F 2/46**, C08G 18/50, C08G 18/81, C08L 75/14

(30) Priority: **22.12.89 US 455153**

(43) Date of publication of application: **26.06.91 Bulletin 91/26**

(84) Designated Contracting States: **AT BE CH DE DK ES FR GB GR IT LI LU NL SE**

(71) Applicant: **UNION CARBIDE CHEMICALS AND PLASTICS COMPANY, INC.**
**39 Old Ridgebury Road**
**Danbury Connecticut 06817-0001(US)**

(72) Inventor: **Gerkin, Richard Michael**
**5300 Kensington Drive**
**Cross Lanes, West Virginia 25313(US)**
Inventor: **Koleske, Joseph Victor**
**1513 Brentwood Road**
**Charleston, West Virginia 25314(US)**

(74) Representative: **Wuesthoff, Franz, Dr.-Ing. et al**
**Wuesthoff & Wuesthoff Patent- und Rechtsanwälte Schweigerstrasse 2**
**W-8000 München 90(DE)**

## (54) Photo-curable urea-containing compositions.

(57) A photocurable composition comprising a multifunctional urea compound, an ethylenically unsaturated compound, and an aromatic ketone photosensitizer that functions through a hydrogen abstraction mechanism and its use in making cured products.

EP 0 434 087 A2

# PHOTO-CURABLE UREA-CONTAINING COMPOSITIONS BACKGROUND TO THE INVENTION

## Field of the Invention

This invention generally relates to radiation curable urea-containing compositions and photoinitiator compositions useful therein. More particularly the invention relates to photopolymerizations of ethylenically unsaturated compounds using a combination of an aromatic ketone photosensitizer and a multifunctional urea compound.

## Description of the Prior Art

It is known that photopolymerization processes have achieved considerable industrial importance particularly in situations where thin films or layers need to be cured in short times. Typical of such situations are the curing of clear coatings or overprint varnishes, colored coatings, inks, adhesives, printing plates, and the like. Such products are used in a variety of commercial end uses. Although the prime interest is for such thin-film technology, the importance of thick-film or thick-section radiation-cured technology is growing and increasing in importance. Thick-section technology is important in the area of sealants, adhesives, shaped parts, printing plates, fiber glass- or carbon/graphite fiber-reinforced products, and the like.

The use of aromatic ketones such as benzophenone, benzophenone derivatives, and the like as photosensitizers in the photopolymerization of ethylenically unsaturated compounds is also known in the art. However, some photosensitizers, such as benzophenone, will not function when used alone and require the presence of a second compound, a synergist. In addition, markedly faster polymerization rates can be obtained by the use of combinations of such aromatic ketones with synergists than is the case when such photosensitizers are used alone. The synergists usually are low molecular weight tertiary amines, ureas, or amides.

Combinations of photosensitizers and synergists that are commonly used include mixtures of one or more aromatic ketones, one of which is benzophenone, isopropylthioxanthone, or the like and a low molecular weight tertiary amine such as dimethylethanol amine, triethylamine, bis-(4,4'-dimethylamino)-benzophenone (Michler's ketone), or the like. The combination of photosensitizer and a synergist is termed a photoinitiator system or a photoinitiator combination. Such combinations are said to function through an intermolecular hydrogen abstraction mechanism in which ultraviolet light is absorbed by the aromatic ketone which interacts with an amine or other suitable low molecular weight nitrogen-containing compound that has an alpha-hydrogen and rapidly forms an excited complex. This complex, or "exiplex" as it is often termed, undergoes rearrangement with the transfer of a hydrogen atom from the amine causing the amine to become the free radical initiator molecule that causes rapid polymerization of acrylates and other appropriate ethylenically unsaturated compounds. If used alone, the amine or other nitrogen-containing compound will not effect polymerization. Although this mechanism is felt to be true, this invention is not limited by it or any other described mechanism.

The use of low molecular weight ureas in polymerization reactions activated by radiation has been described in the art. U. S. Patent No. 3,993,549 describes the addition of powdered urea to liquid-polyene-polythiol systems that are to be cured with actinic radiation such as ultraviolet light or ionizing radiation in the presence of photosensitizers such as aromatic ketones.

U. S. Patent Nos. 4,425,208 and 4,518,473 describe methods for the photopolymerization of ethylenically unsaturated compounds wherein combinations of an aromatic ketone photosensitizer and low molecular weight tetrasubstituted ureas and disubstituted amides are employed as the photoinitiators.

U. S. Patent No. 4,446,247 describes liquid photoinitiator compositions that contain an aromatic ketone photosensitizer and a low molecular weight tetrasubstituted urea or disubstituted amide and that are useful for the radiation activated polymerization of ethylenically unsaturated compounds.

Belgium Patent No. 884,395 deals with the radiation curing of acrylates in combination with low molecular weight compounds of the N-vinyl amide type. The list of suitable compounds in this reference mentions and the patent claims, but does not exemplify, the use of low molecular weight compounds such as N-vinylmethyl-N'-dimethyl urea and other tetrasubstituted, vinyl-containing ureas in combination with acrylates.

Use of low molecular weight amines in combination with aromatic or diaryl ketones to form photoinitiator systems is documented in the literature. For example, G. F. Vesley, J. Radiation Curing, 13 (1), 4 (1986) discusses combination diaryl ketone/amine hydrogen-abstracting initiators for the radiation polymerization of

acrylates. P. N. Green, Polymer Paint Colour J., 175 (4141), 246 (Apr4il 17, 1985) also discusses such compounds and points out that compounds such as benzophenone are usually used in combination with tertiary amines for the ultraviolet light curing of acrylates. Table 9 of this article lists N-methyldiethanolamine, triethanolamine, 2-(dimethylamino)ethylbenzoate, and n-butoxyethyl-4-dimethylaminobenzoate as examples of coinitiator, tertiary amines that are used in the art.

U. S. Patent No. 4,761,435 describes the use of polyamine resins which preferentially are polytertiary amine resins in combination with aryl ketone photosensitizers such as benzophenone. It is preferred that acrylic copolymers containing copolymerized tertiary amine-functional monomers such as dimethylaminoethylacrylate, acrylamide, or methacrylamide be used. It is mentioned that primary amine derivatives of polyoxypropylene compounds can be used and one that is trifunctional in nature with an equivalent weight of 139 (Jeffamine T-403) is listed in a table but is not used in the ensuing examples.

Although such combinations can give very good results in terms of rate of cure, they can have a number of disadvantages. These disadvantages include giving rise to yellowing or other discoloration of the finished polymeric film, unpleasant odors in the liquid formulation and the cured film, health hazards since Michler's ketone is carcinogenic, decreased storage stability, and emulsification in certain application methods, such as web offset printing, when aliphatic amines or alkanolamines are used. Another disadvantage of radiation cured ethylenically unsaturated compounds is poor adhesion that is caused by the large amount of shrinkage that occur during the ethylenic unsaturation polymerization process. Decreasing the amount of ethylenic unsaturation, which is usually present in the form of acrylic functionality, in a coating, ink, or adhesive formulation is advantageous in that it will decrease shrinkage and improve adhesion.

## OBJECTIVES OF THE INVENTION

An object of the present invention is to enhance the mechanical property characteristics such as adhesion, flexibility, softness, gloss, toughness, and/or other functional or decorative properties of coatings, inks, adhesives, sealants, and fabricated parts.

Another object of the present invention is to significantly decrease the amount of ethylenically unsaturated acrylate used in a given formulation, which acrylates are known to be skin and eye irritants and which can have other undesirable health characteristics.

Still another object of the present invention is to provide less system polymerization shrinkage and thus improved inherent adhesion in the final cured film or product.

## SUMMARY OF THE INVENTION

This invention provides for the use of multifunctional urea compounds as aromatic ketone photosensitizer synergists or cophotosensitizers in photo-curable, ethyleneically-unsaturated formulations that are suitable as coatings, inks, adhesives, sealants, and fabricated parts. It has now been found that these combinations give excellent rates of photopolymerization when used in systems that involve the photopolymerization of ethylenic double bonds such as those contained in acrylates without exhibiting the disadvantages described above.

Although it is preferred that the urea compounds of this invention be used with aromatic ketone photosensitizers such as benzophenone, chlorothioxanthone, and the like, that function through an intermolecular hydrogen abstraction mechanism, other photoinitiators can be used. In addition, the aromatic ketone photosensitizers can be used alone, in combination with each other, or in combination with photoinitiators that function via a homolytic fragmentation mechanism when used in combination with the urea compounds and photopolymerizable ethylenically unsaturated compounds. The composition can contain various amounts of the urea compounds wherein said amounts will depend on the molecular weight/equivalent weight of said urea compound and on the desired performance characteristics of the cured product.

The invention also comprises liquid photoinitiator compositions that are combinations or mixtures of the urea compound and one or more aromatic ketone photosensitizers and which can optionally contain photoinitiators that operate via a homolytic fragmentation mechanism.

## DETAILED DESCRIPTION OF THE INVENTION

In accordance with the present invention there is provided ureas of the general formula:

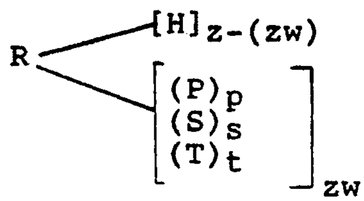

wherein R is an initiator radical based on a compound containing Zerewitinoff active hydrogen atoms and is capable of initiating polymerization with alkylene oxides when used with a suitable catalyst such as potassium hydroxide, zinc hexacyanocobaltate, and the like. It is understood by those skilled in the art that not all of the potential active hydrogen atoms must become activated during the reaction process of making polyols and some of the starting functionality such as hydroxyl may remain on the initiator molecule.

Examples of such compounds that contain Zerewitinoff active hydrogen atoms include but are not limited to difunctional compounds such as ethylene glycol, propylene glycol, water, 1,4-butanediol, diethyleneglycol; trifunctional compounds such as trimethylolpropane, glycerol, trimethylolethane; and other higher functional compounds such as pentaerythritol, sorbitol, sucrose, ammonia, ethylene diamine, 1,3-diaminopropane, 1,6-hexanediamine, isomers of phenylenediamine and toluenediamine, 4,4'-diphenylmethane diamine and its isomers, diethanolamine, ethanolamine, dimethylethanolamine, N-methylethanolamine, triethanolamine, triisopropanolamine, and propylene disulfide.

Additional examples of compounds suitable for initiating polymerization of alkylene oxides are the various oligomeric polyols known in the art. These include the poly(1,4-butylene oxide) polyethers and the hydroxyl- and amine-terminated polybutadienes. When polyols (or other oligomers) are used for initiating polymerization of the alkylene oxides, their molecular weights can range from 400 to 3000 (oligomeric to polymeric). When the conventional initiators such as described above (i.e., glycerine, water, etc.) are used, their molecular weight can range from about 18 up to about 400. Preferably R contains from two to about six carbon atoms.

Examples of R include but are not limited to initiator radicals such as the following:

(1) if R is linear and has three carbon atoms as it would have from glycerol, it would have the structure

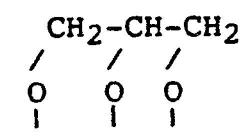

,

(2) if R is branched and has six carbon atoms as it would have from trimethyolpropane, it would have the structure

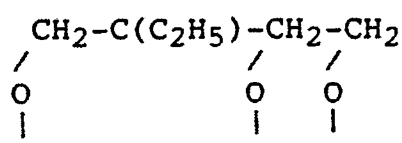

,

and

(3) if R is branched and has 5 carbon atoms as it would have from pentaerythritol and if only three of the active hydrogens had been removed, it would have the following structure

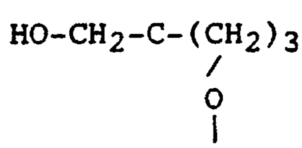

.

(4) if R is linear and difunctional and is derived from a (tetramethylene oxide)polyol or poly (1,4 butylene oxide) as it would have from the initiation and polymerization of tetrahydrofuran with water, it would have

the structure

$$-[O-(CH_2)_4]_d-O-(CH_2)_4-O-$$

wherein d can range from zero to fifty with the preferred range four to 35. Hydroxyl terminated poly (tetramethylene oxide) products obtained by the polymerization of tetrahydrofuran, are commercially available as Polymeg™ and Terethane™ manufactured by Quaker Chemical Company and Dupont Company wherein the initiator is unknown.

The alkylene oxides and other monomers that find utility in the present invention are those well known in the art. These include ethylene oxide, propylene oxide, the alpha-olefin oxides such as 1,2-epoxybutane, and 1,2-epoxyoctadecane, oxetane, and tetrahydrofuran.

"H" represents a hydroxy-containing group of the formula

```
                  CH3          R'             R''
                  /            /              /
-(CH2CH2-O)a(CH2CH-O)b(CH2CH-O)c-(CH2)nCH-O(H)1-y(I)y;
```

"P" represents a primary amine-containing group of the formula

```
                  CH3          R'             R''
                  /            /              /
-(CH2CH2-O)a(CH2CH-O)b(CH2CH-O)c-(CH2)nCH-N(H)2-2u(I)2u;
```

"S" represents a secondary amine-containing group of the formula

```
                  CH3          R'             R'' R'''
                  /            /              /   /
-(CH2CH2-O)a(CH2CH-O)b(CH2CH-O)c-(CH2)nCH-N(H)1-u(I)u;
```

and "T" represents a tertiary amine-containing group of the formula

```
                  CH3          R'             R''R''''
                  /            /              /  /
-(CH2CH2-O)a(CH2CH-O)b(CH2CH-O)c-(CH2)nCH-NR'''
```

wherein:

(1) the letter "a" defines the ethylene oxide content of the amine and can range from a value of zero to 175 with the preferred range being from zero to 90, and, when "b" or "c" is not equal to zero, the most preferred range is from zero to 50,

(2) the letter "b" defines the propylene oxide content of the amine and can also range from a value of zero to 175 with the preferred range being from zero to 115, and the most preferred range from three to 98,

(3) the letter "c" defines the alpha-olefin oxide

```
(CH2-CH-R')
   \ /
    O
```

content of the amine and can range from zero to 30 with the preferred range being from zero to 15 and the most preferred range from zero to 2,

(4) the letter "n" equals an integer equal to from 1 to 3 and preferably 1 or 3,

(5) the letter "y" is 0 to u, and

(6) the letter "u" is relative urea content and can range from zero to 1.0, preferably 0.2 to 1.0 and most preferably 0.4 to 1.0.

Ethylene oxide, propylene oxide, alpha-olefin oxide, and tetramethylene oxide, can be incorporated into the product backbone in any sequential manner, i.e., random or block sequence, in any configuration or conformation.

R' is an alkyl group containing from two carbon atoms to 18 carbon atoms depending on the alpha-olefin oxide used in preparation of the amine. While R' can contain up to 18 carbon atoms, it is most preferred that R' contain two carbon atoms.

R" is hydrogen or an alkyl group containing from one up to 18 carbon atoms with it preferred that R" is hydrogen or an alkyl group with up to two carbon atoms and with it most preferred that R" is hydrogen or a methyl group.

R''' and R'''' are independently an alkyl group containing from two to 12 carbon atoms and preferably containing from two to six carbon atoms.

The group I, which can be the same or different throughout depending on the isocyanate, represents

```
-C-N-R5R6
 ‖ /
 O H
```

wherein $R^5$ is alkyl of one to 10 carbon atoms, alkylene of one to 6 carbon atoms, aryl, arylene, aralkyl, cycloalkyl, phenyl, substituted phenyl, phenylene, substituted phenylene and $R^6$ is hydrogen, alkyl of one to 10 carbon atoms, alkylene of one to 6 carbon atoms, aryl, aralkyl, cycloalkyl, allyl, alkyl or other substituted allyl, vinyl, and alkyl or other substituted vinyl.

p is a mole fraction of the primary aminated portion of the amine reactant and is from 0 to 1.0, preferably from 0 to less than 0.75;

s is a mole fraction of the secondary aminated portion of the amine reactant and is from 0 to 1.0, preferably from 0.25 to 1.0;

t is a mole fraction of the tertiary aminated portion of the amine reactant and is from 0 to 0.7, preferably from 0 to 0.2;

w is the percent amination of the Zerwitinoff active hydrogen atoms on the intermediate compound, generally 30 percent to 100 percent, and preferably 70 percent or more; and

(zw) is the product of z and w;

The sum of p, s, and t must equal 1.0.

The letter "z" is an integer equal to the number of Zerewitinoff active hydrogens on the initiator and must be at least two. The letter "z" is preferably 2 to 6.

The above parameters describe amines with equivalent weights ranging from about 100 to 10,000 or more when the functionality is between 2 and 6 but it is preferred that equivalent weights of from 600 to 10,000 or more be used in the practice of this invention.

The ureas that are useful in the present invention are prepared by direct, catalytic amination of an appropriate polyol such as

```
                          CH3          R'             R''
                          /            /              /
R-[(CH2CH2-O)a(CH2CH-O)b(CH2CH-O)c-(CH2)nCH-OH]z
```

with an amine such as R'''-$NH_2$ or R'''-N(H)-R''''. Details of the procedure for preparation of the compounds can be found in copending United States Patent Application Serial Number 176,222 filed on March 31, 1988 and U.S. Patent No. 3,654,370. This amine terminated polyether is then reacted with an isocyanate to obtain the useful ureas. Illustrative of the isocyanates that can be used to prepare the ureas from the aminated polyol are monoisocyanates such as phenyl isocyanate, hexyl isocyanates, butyl isocyanates, propyl

isocyanates, methyl isocyanate, cyclohexyl isocyanate, as well as other alkyl or aryl isocyanates, 1-(1-isocyanato-1-methylethyl)-4-(1-methylethenyl)-alpha, alpha-dimethyl meta-isopropyl benzyl isocyanate (also known as m-isopropenyl-alpha, alpha-dimethylbenzyl isocyanate), naphthalene isocyanate, 3-isocyanatopropyl triethoxysilane, and the like.

The aromatic ketone photosensitizers are those aromatic ketones which act as photosensitizers and in which a ketonic group is attached directly to a carbon present in an aromatic or unsaturated ring. Illustrative of such compounds are benzophenone and benzophenone derivatives, xanthen-9-one, thioxanthone, 2-chlorothioxanthone, isopropylthioxanthones, 2,3-diethylthioxanthone, sodium-4-(sulphomethyl)benzyl, (4-benzoylbenzyl)trimethylammonium chloride, sodium-4-(sulphomethyl)benzophenone, fluorenone, benzil, bis-(4,4'-dimethylamino)benzophenone, 4-chlorobenzophenone, 4-phenylbenzophenone, 4-p-tolylthiobenzophenone, 2-methylanthraquinone, dibenzosuberone, biacetyl, dodecylthioxanthenones, 9,10-anthraquinone, camphor quinones, 1,3,5-triacetylbenzene, 3-ketocoumarines, acridone, p-diacetylbenzene, 3-acetylphenanthrene, penanthrenquinone, and the like. Preferably, benzophenone or benzophenone derivatives.

Illustrative of the ethylenically unsaturated monomers suitable for use in the invention are the esters of acrylic and methacrylic acid with monohydric and polyhydric compounds, such as methyl, ethyl, propyl, butyl, pentyl, hexyl, octyl, decyl, and the like acrylates and methacrylates as well as the various isomers of these and other listed compounds, neopentyl diacrylate, esterdiol diacrylates such as 2,2-dimethyl-3-hydroxypropyl-2,2-dimethyl-3-hydroxypropionate diacrylate, trimethylolpropane triacrylate, pentaerythriol di-, tri-, and tetraacrylate, hyroxyethyl acrylate, hydroxypropyl acrylate, caprolactone acrylates, ethoxylated acrylates, propyoxylated acrylates, glycerol acrylates, triethylene glycol diacrylate, tetraethylene glycol diacrylate, ethoxyethyl acrylate, cyclohexyl acrylate, 2-phenoxyethyl acrylate, isobornyl acrylate, 1,3-butylene glycol diacrylate, 1,4-butanediol diacrylate, 1,6-hexanediol diacrylate, glycidyl acrylate, as well as the methacrylates of such compounds, and the like; styrene, divinylbenzene; N-vinylpyrrolidone, and the like. Illustrative of the oligomers or polymers which can be used in the photopolymerizable reaction formulations are poly(ethylene glycol) acrylates, caprolactone di-, tri-, and tetraacrylates, tripropylene glycol diacrylate, poly(propylene glycol) acrylates, ethoxylated or propoxylated Bisphenol A diacrylates, alkoxylated esterdiol diacrylates such as ethoxylated or propoxylated 2,2-dimethyl-3-hydroxypropyl-2,2-dimethyl-3-hydroxypropionate diacrylates, acrylates of caprolactone reacted with esterdiols, ethoxylated or propoxylated trimethylolpropane triacrylate, ethoxylated or propoxylated pentaerythriol di-, tri, or tetracrylate, unsaturated polyesters containing ethylenic unsaturation from maleic, fumaric, citraconic, and the like unsaturated dicarboxylic acids, urethane acrylates of various types, epoxy acrylates, acrylated polybutadiene, acrylated linseed oil, acrylated soyabean oil, and the like. Compounds such as those mentioned are known to those skilled in the art and many are commercially available. Preferably the acrylates are employed, such as monoacrylatjes, diacrylates, triacrylates and acrylates of higher functionality.

The photopolymerization process of this invention is conducted in accordance with procedures conventional in the art with the distinguishing feature being the use as the photoinitiator of a combination of an aromatic ketone photosensitizer and as urea compound. The formulations or systems of this invention which are used in the photopolymerization processes comprise one or more photopolymerizable, ethylenically unsaturated monomers, oligomers, and polymers, one or more urea compounds of the present invention, and one or more photosensitizer or mixture of photosensitizer and photoinitiator. The formulations may also contain a variety of additives including stabilizers such as hydroquinone or methyoxyhydroquinone which prevent premature polymerization during preparation, handling, and storage of the system, antioxidants, surfactants or other flow and leveling agents, fillers, pigments, silane or titanium coupling agents, thickeners, inert solvents, inert polymers, waxes, adhesion promotors, slip agents such as the silicone oils, powdered polytetrafluoroethylene and/or polyethylene, and the like which are known to those skilled in the art of coating formulation some of which are discussed in more detail below

The formulations are applied to appropriate substrates as thin films by a variety of processes illustrative of which are roll coating, dip coating, spray coating, brushing, flexographic, lithographic, and offset web printing processes, and the like.

The photopolymerization is carried out by exposing the film or coating to light radiation which is rich in short-wave radiation. Particularly useful is radiation of about 200 to about 450 nanometers in wavelength. Illustrative of appropriate light sources are low pressure, medium pressure, and high pressure mercury vapor lamps, xenon and other flash-type lamps, fluorescent lights, lasers, electrodeless mercury lamps, and the like. Other sources of radiant energy such as electron beams, gamma radiation, X-rays, sunlight, and so on can also be used.

Usually proper selection of the above formulation ingredients will yield systems that are easily applied. However, in certain cases it may be desirable to reduce the viscosity by adding one or more inert or

nonreactive solvents to the systems in amounts of about one to about 25 weight percent for the purpose of improving flow characteristics or for altering other response characteristics. In certain cases, it may be desirable to use more than 25% of the solvent. Illustrative of such solvents are 1,1,1-trichloroethane, butanol, ethanol, ethoxyethanol, ethoxyethyl acetate, ethoxybutanol, ethoxybutanol acetate, butyl acetate, methyl isobutyl ketone, methyl ethyl ketone, methyl amyl ketone, propylene glycol methyl, propyl, and butyl ethers, dipropylene glycol alkyl ethers, and the like. In certain instances it may be desirable to add water or a mixture of water and organic solvent to the coating formulation.

It may also be desirable to thicken certain formulations such as those used for screen printing or other end use requiring special rheological responses. Illustrative of the various inert thickening agents that may be employed are fumed silicas, clays, glass spheres or other microballoons, aluminum trihydrate, polymers such as cellulose acetate butyrate, vinyl polymers, phenoxy, acrylates, and the like. The amount of such materials used in a system is dependent on the desired viscosity, thixotropy, or other flow characteristic and is known by those skilled in the art of formulating coatings, inks, and the like.

Although the components of the formulations are miscible, it may be necessary for times as long as 24 hours or more to elapse under ambient conditions to ensure that a photosensitizer such as benzophenone is well dissolved in the system and that optimum results are obtained. As is known to those skilled in the art of coating formulation such a time is dependent on may factors including formulation components, photosensitizer concentration, temperature, and the like. In special cases, it may be necessary to agitate the system during use to ensure miscibility of all components.

When carrying out the photopolymerizable process or method of the invention, the various components of the system can be brought together in any order using any conventional type of mechanical or manual blending equipment. The aromatic ketone photosensitizer or mixture of aromatic ketone photosensitizers, the urea compound or mixtures of more than one of the urea compounds if desired, and if desired the optional type photoinitiators can be added as separate components to the formulation or they can be preblended and added as a single component. If desired, the mixtures may also contain minor amounts of less than 1 percent to about 2 percent of known synergists such as diethanolamine, triethylamine, or the like. The latter preblending method is sometimes preferred since in many instances all the components of the system other than the photoinitiator composition may be prepared and stored prior to use and the photoinitiator composition is only added immediately before use. In addition, certain aromatic ketone compounds such as benzophenone are solids and require the passage of time to effect dissolution. Preblending will yield a liquid, easily handled and used mixture that is immediately ready for use. This method avoids any possible instability or reactivity problems which might arise if all the components of the system were mixed and then stored for extended periods before use. As known to those skilled in the art of formulating photocurable acrylate systems, the length of shelf storage is variable and depends on such factors as temperature, presence of light and particularly ultraviolet light, air space in container, and the like.

The amount in which the mixture of components is used in the photopolymerizable systems of the invention can vary over a wide range depending on the nature of the system. Generally, from about 2 to about 65 weight percent o the combination aromatic ketone photosensitizer and multifunctional urea compound is used based on the total weight of the photocurable materials. Preferably, 2 to 50 weight percent. The proportion in which the aromatic ketone photosensitizer is blended with the urea compounds of the invention is broad and depends on the molecular weight/equivalent weight of the compounds. In general the aromatic ketone photosensitizer is present in an amount ranging from about 0.5 to about 15 weight percent based on the total photcurable materials. More preferably from about 1 to about 10 weight percent is used. The photoinitiator composition can optionally contain up to about 75 weight percent of a homolytic fragmentation type photoinitiator based on the weight of the mixture of the aromatic ketone photosensitizer, multifunctional urea compound and homolytic photoinitiator.

As mentioned above, a particular embodiment of the invention comprises certain photoinitiator compositions which are mixtures of one or more aromatic ketone photosensitizer that is capable of participating in intermolecular hydrogen abstraction, one or more of the urea compounds, and optionally a photoinitiator of the homolytic fragmentation type. It has been found that such compositions are usually liquid in nature and can be stored for extended periods preferably in the absence of ultraviolet radiation or other light. If desired or if needed to effect solution of the combined compounds, an inert solvent such as those indicated above can be added to the mixture. The photoinitiator composition may optionally contain from zero to 75% by weight of a homolytic fragmentation type photoinitiator illustrative of which are the benzyl ketals, 2,4,6-trimethylbenzoyldiphenylphosphine oxide, acetophenone and derivatives such as 2,2-diethoxyacetophenone, 2,2-dimethoxy-2-phenylacetophenone, 2-hydroxy-2,2-dimethylacetophenone, and the like, 1-benzoylcyclohexan-1-ol, benzoin, alkyl benzoin ethers such as methyl, ethyl, isopropyl, n-butyl, isobutyl benzoin ethers, and the like. If desired, the photoinitiator compositions can contain from 1 to about 25% by weight of

an inert solvent such as those described above. Particularly preferred photoinitiator compositions comprise mixtures of benzophenone and one or more amine compounds of the present invention.

The compositions of the invention can be exposed to radiation in a variety of atmospheres illustrative of which are air, nitrogen, argon and the like. It has been found that the coatings do not require an inert atmosphere for cure and either an active or oxygen-containing atmosphere such as air or an inert atmosphere such as nitrogen can be used.

The use of the compositions or the photoinitiator compositions of the invention gives excellent results in terms of adhesion to a variety of substrates, of rapidity with which cure of the photopolymerizable systems can be effected, in terms of surface finish which may be clear and glossy or matte in appearance, of absence of yellowing, of excellence of mechanical properties when applied in film form as well as low odor systems. In addition, if the photoinitiator compositions are preblended before use, they offer a marked advantage in ease of handling and use. In addition, it has been found that the photoinitiator combinations of the invention can be stored alone or in admixture with the other components of the photopolymerizable systems for substantial periods (four months or more) without showing any signs of instability or being changed in any way in terms of their ability to cure the system on exposure to appropriate radiation.

The compositions of this invention are useful in a variety of end uses. Illustrative of these end uses are general metal coatings for steel, tin plated steel, tin-free steel, galvanized steel, phosphatized or other treated steel, aluminum, copper, tin-lead solders, as well as other metals, appliance coatings, business machine coatings, office equipment coatings, lamp and lighting fixture coatings, beverage and other can coatings, decorative coatings, overprint varnishes, inks, sealants, adhesives, coatings for electronics such as laser markable coatings, conformal coatings, photoresists, solder masks or resists, coatings for optical discs and compact discs, coatings for magnetic tape, coatings for optical fibers, coatings for glass fiber-reinforced polyester materials, coatings for glass or carbon fiber-reinforced composites prepared from unsaturated polyesters and styrene, coatings for sputtered or vapor deposited aluminum, gold or other metals, graphite or carbon fiber reinforced laminates/composites, coatings for glass, wood, plastics such as polyesters, polycarbonate, polysulfone, treated polyethylene and polypropylene, and shaped products such as those prepared using stereo lithography and the like.

Whereas the exact scope of the instant invention is set forth in the appended claims, the following specific examples illustrate certain aspects of the present invention and, more particularly, point out methods of evaluating the same. However, the examples are set forth for illustration only and are not to be construed as limitations on the present invention except as set forth in the appended claims. All parts and percentages are by weight unless otherwise specified.

The coating compositions prepared in the examples below were evaluated according to the following procedures.

Solvent Resistance (Double Acetone Rubs):

A measure of the resistance of the cured film to attack by acetone in which a film coating surface was rubbed with an acetone-soaked cloth back and forth with hand pressure. A rub back and forth over the film coating surface with the acetone soaked cheesecloth was designated as one "double acetone rub." The effect that a certain number of double acetone rubs had on the film coating surface was reported by a number in parenthesis following the number of double acetone rubs. The rating system for evaluating acetone resistance for a given number of double acetone rubs was as follows:

Number in Parenthesis After Number of Rubs

(1) No change in coating appearance
(2) Surface scratched
(3) Surface dulled or marred. some coating removed
(4) Breaks in coating apparent
(5) About 50% or more of coating removed

Pencil Hardness: Pencil leads of increasing hardness values were forced against the film coating surface in a precisely defined manner as described in ASTM D3363-74 until one pencil lead cut through the surface of the film coating. The surface hardness was considered as the hardest pencil grade which just failed to cut or mar the film coating surface. The pencil leads in order of softest to hardest were reported as follows: 6B, 5B, 4B, 3B, 2B, B, HB, F, H, 2H, 3H, 4H, 5H, 6H, 7H, 8H, AND 9H.

Crosshatch Adhesion. A lattice pattern with ten cuts in each direction was made in the coating film to the substrate and pressure-sensitive adhesive tape (Scotch Brand 606) was applied over the scored/cut substrate and then quickly removed as prescribed in ASTM D3359-78. The adhesion was evaluated by comparison with descriptions and illustrations as more fully detailed in the cited method.

Gardner Impact Resistance. A measure of the ability of a cured film coating on a substrate to resist

rupture from a falling weight. A Model IG-1120 Gardner Impact Tester equipped with an eight-pound dart was used to test film coatings cast and cured on steel panels. The dart was raised to a given height in inches and dropped onto either the coated side of the coated steel panel (direct or forward impact resistance) or the uncoated side of the coated steel panel (reverse impact resistance). The height-of-drop in inches times weight of dart (8 pounds), designated as inch-pounds, absorbed by the film without rupturing was recorded as the films direct or reverse impact resistance.

Gloss. Gloss measurements were made at either 20 degrees and/or 60 degrees in accordance with ASTM D523-78 using a Gardner gloss meter equipped with 20 and 60 degree heads.

GLOSSARY

Epoxy Diacrylate I is marketed by SARTOMER as Epoxy Diacrylate C-3000. It has a viscosity of about one million centipoise at 25° C.

Isocyanate I is m-isopropenyl-alpha,alphadimethylbenzyl isocyanate with a molecular weight of 201, a theoretical isocyanate content of 20.9%, and a boiling point of 270° C. It is marketed by American Cyanamide Company under the tradename TMI.

Photoinitiator I is Irgacure™ 184 which is 1-hydroxycyclohexylphenyl ketone and is marketed by Ciba-Geigy Corporation.

Photosensitizer I is Irgacure™ 500 which is a 50/50 mixture of benzophenone and Irgacure™ 184 (Photosensitizer I) that is marketed by Ciba-Geigy Corporation.

Polyamine I is a developmental, trifunctional, isopropylamine-terminated propylene oxide polyol with an amine number of 3.396 meq/g and an equivalent weight of 294.4 that has the following average end group structure

```
                 H  CH3
                 /  /
-----OCH2-CH-N-CH
         /    /
       CH3  CH3.
```

Polyamine II is a developmental, trifunctional, isopropylamine-terminated propylene oxide polyol with an amine number of 0.539 meq/g and an equivalent weight of 1855 that had an average end group structure that was the same as that of Polyamine I described above.

Polyamine III is a developmental, tri-primary-amine-functional propylene oxide compound with an equivalent weight of about 2169 and an amine number of about 0.461meq/g. It contains about 73% primary amine end groups, about 20-25% secondary amine end groups, and about 0 to 5% tertiary amine end groups. If all end groups in a given molecule were primary, it would have the following average structure:

```
          CH3            CH3
          /              /
CH2-O[CH2CH-O]36-(CH2)CH-NH2
/
/        CH3            CH3
/        /              /
CH-O[CH2CH-O]36-(CH2)CH-NH2
/
/         CH3            CH3
/         /              /
CH2-O[CH2CH-O]36-(CH2)CH-NH2.
```

Polyamine/urea I is a mixed amine/urea terminated product prepared from Polyamine III and Isocyanate I in a 2/1 equivalent ratio. The final product had a hazy appearance, a viscosity of 3,985 centistokes at 25° C, an unsaturation content of 0.224 meq/g, and an amine number of 0.209 meq/g.

Polyamine/urea II is a mixed amine/urea terminated product prepared from Polyamine III and Isocyanate

I in a 4/1 equivalent ratio. Approximately 25% of the amine groups were capped with the isocyanate used.

Polyamine/urea III is a mixed amine/urea terminated product prepared from Polyamine III and Isocyanate I in a 1.33/1 equivalent ratio. Approximately 75 percent of the amine groups were capped with the isocyanate used.

Polyurea I is the reaction product of Polyamine I and Isocyanate I. It has the following average, theoretical end group structure:

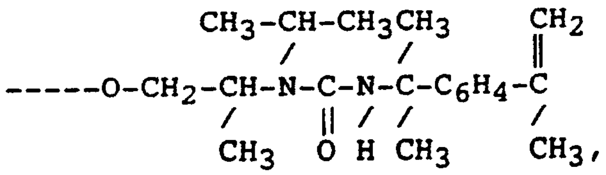

an average equivalent weight of 495, and an average molecular weight of 1485.

Polyurea II is the reaction product of Polyamine II and Isocyanate I. It had the same theoretical, average end group structure as Polyurea I and an average equivalent weight of 2056 and an average molecular weight of 6168.

Polyurea III is the reaction product of Polyamine III and Isocyanate I. It had an unsaturation number of 0.365 meq/g, a total amine number of 0.0225 meq/g, and a viscosity of 7,829 cks at 25° C and the following average theoretical end group structure:

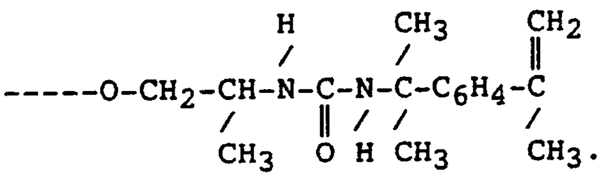

Polyurea IV is prepared from the same ingredients as Polyurea III and has the same average end group structure. It had a hazy appearance, a viscosity of 8,975 centistokes at 25° C, and an unsaturation content of 0.386 meq/g.

Surfactant I is a silicone alkylene oxide surfactant marketed by Union Carbide Corporation under the designation SILWET™ L-7604.

Surfactant II is a silicone alkylene oxide surfactant marketed by Union Carbide Corporation under the designation SILWET™ L-5420.

Urethane Diacrylate C9504 is marketed by SARTOMER and has a viscosity of 167,000 cp at 70 °F, a molecular weight of 1700, and is useful in weatherable coatings.

EXAMPLES

Example 1. 22.2 grams (0.0754 equivalents) of Polyamine I and 15.5 grams (0.0754 equivalents) of Isocyanate I were placed in a glass container which was then loosely capped and allowed to stand at ambient conditions. A significant exotherm to about 40° C was noted and the clear starting compounds rapidly became cloudy. An infrared analysis made after the reactants were held under ambient conditions for about 24 hours indicated the reaction was complete. The compound formed had the following average theoretical end group structure.

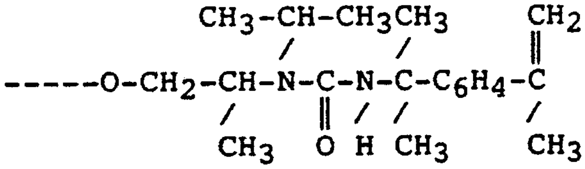

The compound was then stored as Polyurea I for further use.

Example 2. Fifty grams (0.02695 equivalents) of Polyamine II and 15.5 grams (0.02695 meq) of Isocyanate I were placed in a glass container which was then capped and allowed to stand under ambient conditions. A slight exotherm was noted and the clear starting compounds rapidly became cloudy. An infrared analysis carried out about 24 hours after the reactants were mixed indicated the reaction was complete. The compound formed had the same average theoretical end group structure as was indicated in Example 1 for Polyurea I. The compound was designated as Polyurea II and stored for later usage.

Examples 3 and 4. The following ingredients were placed in glass bottles and well mixed to ensure dissolution. They were then coated onto Bonderite 37 steel panels with a #20 wire-wound rod and exposed to ultraviolet light radiation supplied by a 300 watt per inch, focused beam, Type A Fusion Systems ultraviolet light lamp at 10 feet per minute. They were then tested.

| | Control A | | 3 | | Control B | | 4 | |
|---|---|---|---|---|---|---|---|---|
| Ingredient | Grams | Wt. % | Grams | Wt. % | Grams | Wt. % | Grams | Wt. % |
| Polyurea I | 95.0 | 95.0 | 2.10 | 72.9 | ---- | ---- | ---- | ---- |
| Polyurea II | ---- | ---- | ---- | ---- | 95.0 | 95.0 | 3.04 | 77.1 |
| Trimethylol Propane Triacrylate | ---- | ---- | 0.65 | 22.6 | ---- | ---- | 0.723 | 18.3 |
| Photo-initiator I | 5.0 | 5.0 | 0.13 | 4.5 | 5.0 | 5.0 | 0.18 | 4.6 |
| Number of Passes Under Ultraviolet Light Source | 5 | | 5 | | 5 | | 1 | |
| Properties | | | | | | | | |
| Pencil Hardness | Tacky | | 2H | | Tacky | | 2H | |
| Crosshatch Adhesion | --- | | 100% | | --- | | 100% | |

It should be pointed out that the Example 3 mixture was tack free after one pass under the ultraviolet light source and was given four more passes to be consistent with the radiation dosage or exposure given to Control A. These results demonstrate that the urea products, Polyurea I and Polyurea II, of Examples 1 and 2 (Controls A and B) do not respond to radiation alone. However, as exemplified by Examples 3 and 4, when small amounts of an acrylate are added to Polyurea I and Polyurea II, the systems readily undergo polymerization and cure to yield films that have good properties and are useful as coatings or varnishes.

Example 5. Equal portions by weight of the mixtures of Examples 3 and 4 were combined in a glass bottle, well mixed, coated onto Bonderite 37 steel panels, and passed once under the same ultraviolet light source as described in the previous example at a rate of 10 feet per minute. The tack free, hard film that resulted had a thickness of 2 mils after cure, had 100% crosshatch adhesion, and had a direct Gardner Impact resistance of 100 inch-pounds. A second cured film prepared in the same manner from the same mixture had a thickness of 40 mils, good adhesion, and a 2H pencil hardness. This example demonstrates that combinations of the urea-containing compounds can be blended with acrylates and photosensitizers and cured in both thin and thick films. Thus, the formulations of this invention are useful as coatings (thin

film) or sealants (thick films) or shaped parts (thick films).

Example 6. This example describes the preparation of another multifunctional urea compound. One hundred and fifty grams (0.069 equivalents) of Polyamine III were placed in a 500 cc, 4-necked reaction flask equipped with stirrer, thermometer, thermowatch, and nitrogen inlet/outlet and heated to 70° C. Then, 13.9 grams (0.069 equivalents) of Isocyanate I were added and the temperature decreased to 69° C. In a few minutes the system exothermed to 74° C. The reaction was allowed to proceed for a total of five hours at 70° C. An infrared analysis indicated the reaction was complete. The cloudy product was designated as Polyurea III and stored for future use.

Examples 7-9. The following ingredients were placed in glass bottles and well mixed to ensure dissolution. They were then coated onto Bonderite 37 steel panels with a #20 wire-wound rod and exposed to ultraviolet light radiation supplied by a four-inch, 100 watt per inch, medium pressure mercury vapor lamp that was about 5.5 inches from the substrate in a nonfocused position. Exposure time used is indicated below. After ultraviolet light exposure and cure, the coated substrates were tested.

| Ingredient, grams | Control C | Control D | Control E | 7 | 8 | 9 |
|---|---|---|---|---|---|---|
| Polyurea III | --- | --- | --- | 4.90 | 4.90 | 7.40 |
| Trimethylol propane triacrylate | 9.90 | 9.90 | 9.90 | 5.00 | 5.00 | 2.50 |
| Benzophenone | 0.10 | 0.30 | --- | 0.10 | 0.30 | 0.10 |
| Photoinitiator I | --- | --- | 0.30 | --- | --- | --- |
| UV exposure time, min. | 5 | 5 | 3 | 3 | 3 | 3 |
| Cure atmosphere | $N_2$ | $N_2$ | $N_2$ | $N_2$ | $N_2$ | $N_2$ |
| Test Results | | | | | | |
| Double Acetone Rubs | * | * | >100 | >100 | >100 | >100 |
| Pencil Hardness | * | * | 2H | 2H | F | <4B |
| Crosshatch Adhesion | * | * | 0B | 4B | 4B | 5B |

* No properties were determined for Controls C and D because after the long exposure time of five minutes, the systems remained low viscosity liquids and no apparent reaction had taken place.

The systems of Examples 7 and 8 were also cured in an air atmosphere for the indicated times. The cured coatings had the indicted properties.

| Property | EXAMPLE 7 | 8 |
|---|---|---|
| Cure Atmosphere | AIR | AIR |
| Cure Time, min. | 3 | 2 |
| Double Acetone Rubs | >100 | >100 |
| Pencil Hardness | 2H | F |
| Crosshatch Adhesion | 4B | 4B |

Thus as shown by the results obtained with Controls C and D, trimethylol propane triacrylate, an acrylate known to be useful in radiation-cure formulations, does not cure/react or only does so at an extremely slow rate when used with a photoinitiator, benzophenone, of the type known to function via an intermolecular hydrogen abstraction mechanism. This is true under the most favorable condition of having a nitrogen atmosphere. When the same acrylate is combined with polymeric ureas, reaction proceeds rapidly in both the favorable nitrogen atmosphere and the less favorable air atmosphere thus demonstrating the usefulness of the systems of this invention. Further, when trimethylolpropane is combined with a homolytic fragmentation type photoinitiator, Photoinitiator I, it reacts/cures but yields a film with no adhesion to the Bonderite 37 substrate. In contrast, the polyurea containing systems of this invention have excellent adhesion to the substrate.

Examples 10-13. The following ingredients were placed in glass bottles and well mixed to ensure dissolution. They were then coated onto Bonderite 37 steel panels with a No.15 wire-wound rod and exposed to the same ultraviolet light source as described in Examples 7 to 9 for three minutes in an air atmosphere.. After exposure they were tested and the indicated results were obtained.

| Ingredients, g | EXAMPLE 10 | 11 | 12 | 13 |
|---|---|---|---|---|
| Polyurea III | 1.90 | 3.90 | 5.90 | 7.90 |
| Trimethylolpropane triacrylate | 8.00 | 6.00 | 4.00 | 2.00 |
| Benzophenone | 0.10 | 0.10 | 0.10 | 0.10 |
| **Test Results** | | | | |
| Double Acetone Rubs | >100 | >100 | >100 | >100 |
| Pencil Hardness | 5H | 2H | B | <6B |
| Crosshatch Adhesion | 4B | 4B | 5B | 5B |
| **Gardner Impact, in-lbs** | | | | |
| Direct | 20 | 25 | 37 | 50 |
| Reverse | <5 | <5 | <5 | 25 |

These results indicate that the coating film properties such as hardness and toughness can be altered or controlled when various amounts of the polyurea are used in the compositions of this invention. In all cases the systems had very good to excellent adhesion indicating that the polyureas are functioning as adhesion promotors as well as tougheners/flexibilizers. Solvent resistance as measured by acetone double rubs is excellent for all coatings investigated.

Example 14. This example describes the preparation of a multifunctional urea compound. Seven hundred and fifty grams (0.346 equivalents) of Polyamine III were placed in a two-liter, four-neck flask equipped with a mechanical stirrer, thermometer, thermowatch, feeding port, and a nitrogen inlet/outlet, purged with nitrogen, and heated to 70 C under a nitrogen blanket. Then, 69.5 grams (0.346 equivalents) of Isocyanate I were added in a steady stream over a five minute time period. When an exotherm began, the heating mantel was removed. The reacting system exothermed 10 Celsius degrees. As the reaction proceeded, the reaction mixture took on a hazy or cloudy appearance. After 1.5 hours an infrared analysis indicated the isocyanate/amine to urea reaction was complete and one-half hour later the product was allowed to cool to room temperature under a nitrogen blanket. The product had a hazy appearance, a viscosity of 8,975 centistokes at 25° C, and an unsaturation content of 0.386 meq/g. It was then labeled as Polyurea IV and stored for later usage.

Example 15. This example describes the preparation of a partially isocyanate capped polyamine that was prepared from the same amine-terminated propylene oxide polyol and isocyanate described in Example 14. The same equipment as used in Example 14 was also used. As will be readily understood by those skilled in the art, the final product is a mixture of compounds that can contain all urea/vinyl end groups, a mixture of amine and urea/vinyl end groups, or all amine end groups. Four hundred and fifty grams (0.207 equivalents) of the amine-terminated polyol were charged to the reaction flask and purged with nitrogen. It was heated to 70° C under a nitrogen blanket and then 20.9 g (0.104 equivalents) of the isocyanate were added. The system exothermed to 80° C and took on a hazy appearance as the reaction proceeded. After a 3.5 hour reaction period at 70° C, an infrared analysis indicated the reaction was completed. The final product had a hazy appearance, a viscosity of 3,985 cks at 25° C, an unsaturation content of 0.224 meq/g, and an amine number of 0.209 meq/g. The product was designated Polyamine/urea I and stored for future use.

Examples 16 and 17. The following ingredients were placed in a glass container and well blended to ensure dissolution. They were then applied to a Bonderite 37 steel panel with a #15 wire-wound rod. A portion of the wet, uncured coating was then covered or masked with an opaque, dendritic shaped mask to simulate the style mask used in photoresist applications. The coated and masked panel was then exposed to the ultraviolet light radiation source described in Examples 7 to 9 for three minutes in an air atmosphere. After exposure the mask was removed. The coating that was under the mask and that did not "see" the ultraviolet light radiation was liquid in nature whereas the coating that was not under the mask and that was exposed to the ultraviolet light was tack free and solid in nature. The the panels were then washed with acetone and the liquid coating was removed without affecting the solid coating leaving the mask area free of coating and available for copper plating, silver electrodeposition, or other subsequent operation. The solid coating had the properties indicated in the following table.

| | Example | |
|---|---|---|
| Ingredients, g | 16 | 17 |
| Polyurea IV | 5.0 | ---- |
| Polyamine/urea I | --- | 5.0 |
| Trimethylolpropane Triacrylate | 5.0 | 5.0 |

| | | |
|---|---|---|
| Benzophenone | 0.1 | 0.1 |
| **Properties** | | |
| Double Acetone Rubs | >100 | >100 |
| Pencil Hardness | 2H | F |
| Crosshatch Adhesion | 5B | 5B |
| Film appearance | Matte | Matte |

Another set of Bonderite 37 panels were coated with the formulations described above, the same mask was applied, and the systems were exposed to ultraviolet light as described above. After exposure, the coating films were washed with dilute (2%) aqueous hydrochloric acid solution to remove the wet, uncured coating. The uncured coating was removed leaving the solid coating unaltered and the area of wet coating removal free for subsequent copper plating, silver electrodeposition, or the like.

Thus, it has been demonstrated that high quality coatings that are suitable for use as photoresists, solder masks, and similar products as well as general purpose coatings can be prepared from the compositions of this invention.

Example 18 and 19. In the same manner as described in Examples 16 and 17 except no opaque mask was used, the following ingredients were mixed, cured, and tested. The cured coatings had high gloss and good definition of reflected images.

| Ingredients, g | Example 18 | Example 19 |
|---|---|---|
| Polyamine/urea | 5.0 | 5.0 |
| Trimethylolpropane Triacrylate | 5.0 | 5.0 |
| Surfactant I | 0.05 | 0.05 |
| Photosensitizer I | 0.30 | ---- |
| Photoinitiator I | ---- | 0.30 |
| **Properties** | | |
| Double Acetone Rubs | >100 | >100 |
| Pencil Hardness | 2B | 2B |
| Crosshatch Adhesion | 5B | 5B |

Thus, the compositions of this invention will cure when photoinitiators of the homolytic fragmentation type are used as well as when mixtures of the intermolecular hydrogen abstraction type photosensitizer and homolytic fragmentation type photoinitiator are used.

Example 20 and 21. The same procedure as given in Example 15 was followed. The following

ingredients were charged to the reaction flask and reacted at 70 OC for the indicated times to produce partially capped polyureas from amine-terminated polyols and isocyanate. Again, it will be understood by those skilled in the art that the final product is a mixture of compounds.

| Ingredients, g | Example 20 | Example 21 |
|---|---|---|
| Polyamine III | 200 (0.0922 eq) | 200 (0.0922 eq) |
| Isocyanate I | 4.63 (0.0231 eq) | 13.9(0.0693 eq) |
| Ratio of Amine to Isocyanate Equivalents | 4.0 | 1.33 |
| Percent of Amine Groups Capped | 25 | 75 |
| Exotherm | 5-10°C | N 10°C |
| Reaction Time at 70°C | 1 hr | 1 hr |
| Product Designation—Polyamine/urea | II | III |

Infrared analysis indicated that all isocyanate had reacted and the desired product mixture was made. The products were labeled as indicated in the table and stored for future use.

Examples 22-25. The following ingredients were placed in glass bottles and well mixed to ensure dissolution. They were then coated onto Bonderite 37 steel panels with a No. 15 wire wound rod, and exposed to ultraviolet light radiation in the same manner as described in Examples 16 and 17 except that a six-minute ultraviolet light exposure was used to ensure complete cure of coatings that were applied with wire-wound rods that yielded thick coatings as is described after the following tabulated data. The cured coatings were then tested.

| Ingredients, g | Example 22 | Example 23 | Example 24 | Example 25 |
|---|---|---|---|---|
| Polyamine/urea II | 5.0 | ---- | ---- | ---- |
| Polyamine/urea I | ---- | 5.0 | ---- | ---- |
| Polyamine/urea III | ---- | ---- | 5.0 | ---- |
| Polyurea IV | ---- | ---- | ---- | 5.0 |
| Trimethylolpropane Triacrylate | 5.0 | 5.0 | 5.0 | 5.0 |
| Benzophenone | 0.3 | 0.3 | 0.3 | 0.3 |

| | | | | |
|---|---|---|---|---|
| Surfactant II | 0.1 | 0.1 | 0.1 | 0.1 |
| **Properties** | | | | |
| Double Acetone Rubs | >100 | >100 | >100 | >100 |
| Pencil Hardness | F | H | F | H |
| Crosshatch Adhesion | 4B | 5B | 4B | 4B |
| Type Finish | ** | *** | **** | ***** |

**Textured finish
***Textured finish
****Partially textured finish
*****Matte finish that was textured at the edges.

The formulation of Example 23 was also applied to Bonderite 37 steel panels with various wire-wound rods to determine if thicker coatings than those obtained with a No. 15 wire-wound rod (ç0.8 mil) would cure. The results are as follows.

No. 22 wire-wound rod--Cured, textured finish, ç1.3 mils
No. 40 wire-wound rod--Cured, textured finish, ç2.5 mils
No. 80 wire-wound rod--Cured, textured finish, ç3.75 mils

In another experiment, a double coating was made with a No. 22 wire-wound rod by first drawing down a coating and curing it by exposure to ultraviolet light and then drawing down a second coating on top of the first coating and curing it with ultraviolet light. The final finish was textured and demonstrated good intercoat adhesion. Thickness was about 3.5 mils.

Examples 26. Five grams of the Polyurea IV, five grams of trimethylolpropane triacrylate, 0.5 gram of TONET M-100 (a caprolactone acrylate with an average molecular weight of about 344 and marketed by Union Carbide Corp.), and 0.1 gram of benzophenone were placed in a glass bottle and well mixed to ensure dissolution of the ingredients. They were then coated onto Bonderite 37 steel panels with a No. 15 wire-wound rod and cured by exposure to the ultraviolet light source used in Examples 7-9 for five minutes in an air atmosphere. The resulting coating had a matte finish and very good solvent resistance (double acetone rubs of 100 (2)), a pencil hardness of B, a crosshatch adhesion rating of 5B, and a Gardner Impact Resistance of 50 in-lbs in the direct direction and of <5 in-lbs in the reverse direction.

Example 27-29. The following ingredients were combined, exposed to ultraviolet light, and tested in the same manner as described in Examples 7 to 9 except that the exposure time was six minutes in an air atmosphere. A long exposure time was used to ensure complete cure and to determine if discoloration took place. No discoloration was noted in the cured coating films.

| | EXAMPLE | | |
|---|---|---|---|
| **Ingredients, g** | 27 | 28 | 29 |
| Polyurea IV | 2.00 | 2.00 | 4.00 |
| Trimethylolpropane Triacrylate | 4.00 | 4.00 | 3.00 |
| Urethane Diacrylate C9504 | 4.00 | 4.00 | 3.00 |
| Surfactant II | —— | 0.10 | 0.10 |

| | | | |
|---|---|---|---|
| Benzophenone | 0.10 | 0.10 | 0.10 |
| **Properties** | | | |
| Acetone Double Rubs | >100 | >100 | >100 |
| Pencil Hardness | 2H | 2H | HB |
| Crosshatch Adhesion | 4B | 5B | 5B |
| Gardner Impact, in-lbs | | | |
| Direct | 25 | 25 | 50 |
| Reverse | <5 | <5 | <5 |
| Type Finish | Matte | Matte | Matte |

Example 30. To demonstrate the stability of the compositions of this invention, the formulation of Example 7 was aged under ambient conditions for 3.75 months and then applied to poly(ethylene terephthalate) film and ABS (acrylonitrile/butadiene/styrene) substrates with a No. 15 wire-wound rod, cured for four minutes in an air atmosphere using the light source described in Examples 7-9, and tested for adhesion. No noticeable change in viscosity had taken place, the draw down were easily made, and the coatings cured well. Adhesion to the plastic substrates was very good.

Example 31-34. The following ingredients were placed in glass bottles, well mixed and stored for future use. In addition to demonstrating ultraviolet light curing ability of the systems, they will demonstrate that various amounts of the photosensitizer, benzophenone, can be used in the compositions of the invention and that the compositions can be cured with different ultraviolet light sources, in different atmospheres (air or nitrogen), and at different cure speeds (conveyor speeds).

| | Example | | | |
|---|---|---|---|---|
| **Ingredients, g** | 31 | 32 | 33 | 34 |
| Polyurea IV | 50.0 | 50.0 | 50.0 | 50.0 |
| Trimethylolpropane Triacrylate | 50.0 | 50.0 | 50.0 | 50.0 |
| Benzophenone | 1.0 | 3.0 | 5.0 | 8.0 |
| Viscosity, cps (25°C) | ---- | 1170 | ---- | ---- |

These formulations were cured with the following ultraviolet light sources under the conditions indicated.

Cure Unit I. A commercial PS-7001 ultraviolet light photocure system that is marketed by Photocure Systems of Union Carbide Corp. It is equipped with a conveyor system (maximum cure speed achievable was 68 fpm), a nitrogen delivery system that can produce a variety of nitrogen atmospheres or that can be turned off and allow an air atmosphere to be used, and 100 watt-per-inch, unfocused, medium-pressure mercury-vapor lamps to produce the ultraviolet radiation conditions. The unit was also equipped with two low intensity, ultraviolet light-producing germicidal lamps that could be used for preferential surface cure before entering the above described ultraviolet light atmosphere and that could be in either an "ON" or an "OFF" status. Cure Unit I denotes an ultraviolet light cure system with these lamps in an "OFF" status. The unit was further equipped with an ancillary 300 watt per inch, focused ultraviolet light lamp that could be in either an "ON" or an "OFF" status. Cure Unit I denotes an ultraviolet light cure system with this lamp in an "OFF" status.

Cure Unit II is the same as Cure Unit I except the two germicidal lamps were in an "ON" status.

Cure Unit III was an ultraviolet light cure system that involved only the conveyor system and the focused, 300 watt per inch ultraviolet light lamp of Cure Unit I in an "ON" status.

The compositions of the indicated examples were coated with a No. 15 wire-wound rod onto either Bonderite 37 steel (B-37), unwaxed, uncoated vinyl tile such as the type used to manufacture home/industrial flooring (Vinyl Tile), or onto MYLART polyester film. The coated substrates were then exposed to ultraviolet light and cured in the manner described in the following tables. The cured coatings were tested using the methods described above.

| Composition of EXAMPLE | 31 | 31 | 33 |
|---|---|---|---|
| <u>UV Cure System</u> | | | |
| Cure Unit I | Used | ---- | Used |
| Cure Unit II | Used | ---- | Used |
| Cure Unit III | ---- | Used | ---- |
| <u>Cure Atmosphere</u> | | | |
| Nitrogen ($ft^3$/hr/ lineal ft of conveyor belt | Used | ---- | |

| | | | |
|---|---|---|---|
| Used width) | (300) | ---- | (150) |
| Air | ---- | Used | ---- |
| Substrate | B-37 | B-37 | B-37 |
| <u>Cure Rate</u> | | | |
| Conveyor Speed, feet/minute | 10 | 30 | 30 |
| No. of Passes | 1 | 1 | 3 |
| <u>Test Results</u> | | | |
| Double Acetone Rubs | 100 (1) | 100 (1) | 100 (1) |
| Pencil Hardness | 2B | HB | HB |
| Crosshatch Adh. | 4B | 5B | 5B |
| <u>Gloss</u> | | | |
| 20 Degree | -- | 40 | 67 |
| 60 Degree | -- | 74 | 78 |
| Surface Appearance* | W | SG | SSG |

* W = Wrinkled; SG = Smooth and Glossy; SSG = Smooth, Semi-Gloss

| Composition of EXAMPLE | <u>32</u> | <u>32</u> | <u>32</u> | <u>32</u> | <u>32</u> |
|---|---|---|---|---|---|
| <u>UV Cure System</u> | | | | | |
| Cure Unit I | Used | Used | ---- | ---- | ---- |
| Cure Unit II | ---- | Used | ---- | ---- | ---- |
| Cure Unit III | ---- | ---- | Used | Used | Used |
| <u>Cure Atmosphere</u> | | | | | |
| Air | Used | Used | Used | Used | Used |

| Substrate | B-37 | B-37 | MYLAR | Vinyl Tile | B-37 |
|---|---|---|---|---|---|
| <u>Cure Rate</u> | | | | | |
| Conveyor Speed, feet/minute | 10 | 10 | 30 | 50 | 10 |
| No. of Passes | 1 | 1 | 2 | 3 | 1 |
| <u>Test Results</u> | | | | | |
| Double Acetone Rubs | 100 (1) | 100 (1) | --- | --- | 100 (1) |
| Pencil Hardness | B | 5B | --- | --- | HB |
| Crosshatch Adh. | 5B | 5B | GOOD | GOOD | 4B |
| <u>Gloss</u> | | | | | |
| 20 Degree | 67 | -- | -- | -- | 55 |
| 60 Degree | 85 | -- | -- | -- | 84 |
| Surface Appearance* | SG | T | M | M | SG |

* SG = Smooth and Glossy; T = Textured; M = Matte

| Composition of EXAMPLE | <u>34</u> | <u>34</u> | <u>34</u> | <u>34</u> | <u>34</u> |
|---|---|---|---|---|---|
| <u>UV Cure System</u> | | | | | |
| Cure Unit I | Used | Used | Used | Used | ---- |
| Cure Unit II | Used | Used | ---- | Used | Used |
| Cure Unit III | ---- | ---- | ---- | ---- | Used |
| <u>Cure Atmosphere</u> | | | | | |
| Nitrogen ($ft^3$/hr/ lineal ft of conveyor belt width) | Used (300) | Used (300) | Used (300) | Used (300) | ---- ---- |

| | | | | | |
|---|---|---|---|---|---|
| Air | ---- | ---- | ---- | ---- | Used |
| Substrate | B-37 | MYLAR | B-37 | B-37 | B-37 |
| Cure Rate | | | | | |
| Conveyor Speed, feet/minute | 10 | 5 | 50 | 30 | 30 |
| No. of Passes | 1 | 1 | 2 | 1 | 1 |
| Test Results | | | | | |
| Double Acetone Rubs | 100 (1) | --- | 100 (5) | 100 (1) | 100 (5) |
| Pencil Hardness | 2B | --- | 6B | 2B | 6B |
| Crosshatch Adh. | 2B | GOOD | 4B | 4B | 5B |
| Gloss | | | | | |
| 20 Degree | -- | -- | 18 | -- | -- |
| 60 Degree | -- | -- | 56 | -- | -- |
| Surface Appearance* | T | T | SemiG | M | T |

* T = Textured; SemiG = Semi-Gloss; M = Matte

Examples 35-36. The following ingredients were placed in glass bottles and well mixed to ensure dissolution.

| Ingredients, g | Example 35 | Example 36 |
|---|---|---|
| Polyurea IV | 20.0 | 40.0 |
| Trimethylolpropane Triacrylate | 40.0 | 40.0 |
| Epoxy Diacrylate I | 40.0 | 20.0 |

| | | |
|---|---|---|
| Benzophenone | 3.0 | 3.0 |
| Surfactant II | 0.5 | 0.5 |

After dissolution of the photosensitizer, benzophenone, the example mixtures were coated onto various substrate with a Number 15 wire-wound rod and exposed to various ultraviolet light Cure Systems that were described in Examples 31-34. The various runs made with the compositions of these examples, which are designated as Run 35-1, 35-2, etc., 36-1, 36-2, etc. are made with the compositions cured on a variety of substrates, and various cure conditions. These examples demonstrate that epoxy acrylates as well as other acrylates can be used in combination with the polyurea-containing compositions of this invention and thus further exemplify the broad utility of the polyureas in ultraviolet light-cured compositions that contain photosensitizers, such as benzophenone, that functions through a hydrogen abstraction mechanism. The various substrates that the compositions were cured on include Bonderite 37 steel (B-37), printed cardboard carton stock (Paper), MYLART polyester film, wood, polycarbonate film (PC), flame-retarded epoxy/fiberglass sheeting (FR-4), copper-clad flame-retarded epoxy/fiberglass sheeting (Cu), alkyd-primed cold-rolled steel (P-Stl), acrylonitrile/butadiene/styrene molded plaques (ABS), and uncoated, unwaxed vinyl tile of the type used in home and industrial flooring (Vinyl Tile). The results of the testing are as follows.

| Run Number | 35-1 | 35-2 | 35-3 | 35-4 | 35-5 |
|---|---|---|---|---|---|

| Composition of EXAMPLE | 35 | 35 | 35 | 35 | 35 |
|---|---|---|---|---|---|
| <u>UV Cure System</u> | | | | | |
| Cure Unit I | Used | Used | Used | ---- | ---- |
| Cure Unit II | ---- | Used | ---- | ---- | ---- |
| Cure Unit III | ---- | ---- | Used | Used | Used |
| <u>Cure Atmosphere</u> | | | | | |
| Nitrogen ($ft^3$/hr/ lineal ft of conveyor belt width) | Used (250) | Used (300) | Used (200) | ---- ---- | ---- ---- |
| Air | ---- | ---- | ---- | Used | Used |
| Substrate | B-37 | PC | B-37 | Wood | MYLAR |
| <u>Cure Rate</u> | | | | | |
| Conveyor Speed, feet/minute | 66 | 10 | 50 | 50 | 50 |
| No. of Passes | 2 | 1 | 1 | 2 | 2 |
| <u>Test Results</u> | | | | | |
| Double Acetone Rubs | 100 (4) | --- | 100 (1) | -- | -- |
| Pencil Hardness | F | --- | 2H | -- | -- |
| Crosshatch Adh. | 4B | FAIR | 5B | 5B | GOOD |
| <u>Gloss</u> | | | | | |
| 20 Degree | 76 | -- | 87 | -- | -- |
| 60 Degree | 81 | -- | 87 | -- | -- |
| Surface Appearance* | SG | T | SG | SG | SG |

* T = Textured; SG = Smooth and Glossy

| Run Number | 35-6 | 35-7 | 35-8 | 35-9 | 35-10 | 35-11 |
|---|---|---|---|---|---|---|
| Composition of EXAMPLE | 35 | 35 | 35 | 35 | 35 | 35 |
| UV Cure System | | | | | | |
| Cure Unit I | ---- | ---- | ---- | ---- | ---- | Used |
| Cure Unit II | ---- | ---- | ---- | ---- | ---- | ---- |
| Cure Unit III | Used | Used | Used | Used | Used | ---- |
| Cure Atmosphere | | | | | | |
| Nitrogen ($ft^3$/hr/ lineal ft of conveyor belt width) | ---- ---- | ---- ---- | ---- ---- | ---- ---- | ---- ---- | Used (150) |
| Air | Used | Used | Used | Used | Used | ---- |
| Substrate | ABS | P-Stl | FR-4 | Cu | B-37 | Paper |
| Cure Rate | | | | | | |
| Conveyor Speed, feet/minute | 12 | 12 | 12 | 12 | 40 | 30 |
| No. of Passes | 1 | 1 | 1 | 1 | 1 | 1 |
| Test Results | | | | | | |
| Double Acetone Rubs | -- | -- | -- | -- | 100 (1) | -- |
| Pencil Hardness | -- | -- | -- | -- | H | -- |
| Crosshatch Adh. | 5B | 5B | 0B | 0B | 5B | GOOD |
| Gloss | | | | | | |
| 20 Degree | 35 | 90 | 56 | 89 | 84 | 42 |
| 60 Degree | 81 | 88 | 87 | 93 | 89 | 72 |
| Surface Appearance* | SG | SG | SG | SG | SG | SG |

* SG = Smooth and Glossy

Run 35-12. The coating of Run 35-4, which was made on a wood substrate, was sanded with a fine sandpaper and a second coating of the same composition (Example 35) was applied with a No. 15 wire-wound draw down rod. The liquid coating wet the sanded substrate well and was exposed in an air atmosphere twice at 50 feet per minute to the same ultraviolet light source as was used for Run 35-4. The resulting coating was hard and tack free and had a 5B crosshatch adhesion, 20° gloss of 66 and 60° gloss of 83, and was smooth and glossy in appearance.

| Run Number | 36-1 | 36-2 | 36-3 | 36-4 | 36-5 |
|---|---|---|---|---|---|
| Composition of EXAMPLE | 36 | 36 | 36 | 36 | 36 |
| <u>UV Cure System</u> | | | | | |
| Cure Unit I | Used | Used | ---- | Used | Used |
| Cure Unit II | Used | Used | ---- | ---- | Used |
| Cure Unit III | ---- | ---- | Used | Used | Used |
| <u>Cure Atmosphere</u> | | | | | |
| Nitrogen ($ft^3$/hr/ lineal ft of conveyor belt width) | Used (300) | Used (300) | ---- ---- | Used (200) | Used (200) |
| Air | ---- | ---- | Used | ---- | ---- |

| | | | | | |
|---|---|---|---|---|---|
| Substrate | B-37 | B-37 | B-37 | B-37 | B-37 |
| <u>Cure Rate</u> | | | | | |
| Conveyor Speed, feet/minute | 67 | 50 | 50 | 35 | 35 |
| No. of Passes | 1 | 1 | 2 | 1 | 1 |
| <u>Test Results</u> | | | | | |
| Double Acetone Rubs | 100 (2) | 100 (1) | 100 (1) | 100 (1) | 100 (1) |
| Pencil Hardness | 3B | HB | 3B | 3B | 4B |
| Crosshatch Adh. | 5B | 5B | 5B | 5B | 5B |
| <u>Gloss</u> | | | | | |
| 20 Degree | 75 | -- | -- | -- | -- |
| 60 Degree | 83 | -- | -- | -- | -- |
| Surface Appearance* | SG | T | M | M | M |

* T = Textured; SG = Smooth and Glossy; M = Matte

| Run Number | 36-6 | 36-7 | 36-8 | 36-9 | 36-10 | 36-11 |
|---|---|---|---|---|---|---|
| Composition of EXAMPLE | 36 | 36 | 36 | 36 | 36 | 36 |
| <u>UV Cure System</u> Cure Unit III | Used | Used | Used | Used | Used | Used |
| <u>Cure Atmosphere</u> | | | | | | |
| Air | Used | Used | Used | Used | Used | Used |
| Substrate | Wood | FR-4 | Cu | P-Stl | ABS | Vinyl Tile |
| <u>Cure Rate</u> | | | | | | |
| Conveyor Speed, feet/minute | 50 | 14 | 14 | 12 | 12 | 30 |

| | | | | | | |
|---|---|---|---|---|---|---|
| No. of Passes | 1 | 1 | 1 | 1 | 1 | 1 |
| Test Results | | | | | | |
| Crosshatch Adh. | — | 5B | 3B | 5B | 5B | FAIR |
| Gloss | | | | | | |
| 20 Degree | 5 | 72 | 90 | 87 | 54 | — |
| 60 Degree | 25 | 78 | 90 | 84 | 80 | — |
| Surface Appearance* | GG | SG | SG | SG | SG | M |

* GG = grainy but glossy; SG = Smooth and Glossy; M = Matte

Run 36-12. The coating of Run 36-6, which was made on a wood substrate, was sanded with a fine sandpaper and a second coating of the same composition (Example 36) was applied with a No. 15 wire-wound draw down rod. The liquid coating wet the sanded substrate well and was exposed in an air atmosphere twice at 50 feet per minute to the same ultraviolet light source as was used for Run 36-6. The resulting coating was hard and tack free and had a 5B crosshatch adhesion, 20° gloss of 53 and 60° gloss of 78, and was smooth and glossy in appearance.

Example 37. This example describes the preparation of a polyurea compound from Polyamine III and phenyl isocyanate. Three hundred grams (0.138 equivalents) of Polyamine III were charged into a two-liter, four-neck flask equipped with a mechanical stirrer, thermometer, thermo-watch, feeding port, and a nitrogen inlet/outlet. The flask was purged with nitrogen and heated to 70 C under a nitrogen blanket. Then, 16.4 g (0.138 equivalents) of phenyl isocyanate were added as rapidly as possible. After a one-hour reaction time at temperature, infrared analysis indicated the reaction was complete and the desired urea reaction pro-duct was obtained. The final product was clear and free of haze and had a viscosity of 6,950 cp at 25 °C. The product was designated as Ex. 37 Polyurea and stored for future use.

Example 38. This example describes the preparation of a polyurea compound from Polyamine III and n-butyl isocyanate. Three hundred grams (0.138 equivalents) of Polyamine III were charged into a two-liter, four-neck flask equipped with a mechanical stirrer, thermometer, thermowatch, feeding port, and a nitrogen inlet/outlet. The flask was purged with nitrogen and heated to 70 °C under a nitrogen blanket. Then, 13.7 g (0.138 equivalents) of n-butyl isocyanate were added as rapidly as possible. After a one-hour reaction time at temperature, infrared analysis in-dicated the reaction was complete and the desired urea reaction product was obtained. The final product was clear and free of haze and had a viscosity of 4,680 cp at 25 °C. The product was designated as Example 38 Polyurea and stored for future use.

Examples 39-43. These examples demonstrate that a variety of polyureas--i.e., reaction products of polyamines and monoisocyanates--can be used in the compositions of this invention. The following ingredients were placed in glass containers and well mixed. After dissolution of the photo-sensitizer, the compositions were drawn down on Bonderite 37 steel panels with a N0. 15 wire-wound rod and cured by ex-posure in an air atmosphere to an American Standard, 300 watt-per-inch medium-pressure mercury-vapor ultraviolet light source at the indicated cure rate (conveyor speed). After exposure to ultraviolet light, the coatings were tested with the method described above.

| Ingredients, g | Example 39 | 40 | 41 | 42 | 43 |
|---|---|---|---|---|---|
| Polyurea IV | 5.0 | --- | --- | --- | --- |
| Example 37 Polyurea | --- | 5.0 | --- | 25.0 | --- |
| Example 38 Polyurea | --- | --- | 5.0 | --- | 25.0 |
| Trimethylol propane triacrylate | 22.5 | 22.5 | 22.5 | 25.0 | 25.0 |
| Epoxy Di-Acrylate I | 22.5 | 22.5 | 22.5 | --- | --- |
| Benzophenone | 1.5 | 1.5 | 1.5 | 1.5 | 1.5 |
| **Cure Conditions** | | | | | |
| Cure Speed, fpm | 30 | 30 | 30 | 10 | 5 |
| No. of Passes | 2 | 1 | 1 | 1 | 2 |
| **Test Results** | | | | | |
| Acetone Double Rubs | 100 (1) | 100 (1) | 100 (1) | 100 (4) | 100 (3) |
| Pencil Hardness | H | H | 2H | 6B | <6B |
| Crosshatch Adhesion | 3B | 4B | 2B | 5B | 5B |

The composition of Example 41 was also exposed once (one pass) in an air atmosphere to the ultraviolet light source at 50 fpm and then evaluated. It had an acetone double rub resistance of 100 (5), a hardness of F, and a crosshatch adhesion rating of 4B. The coating of Example 42 was also exposed once (one pass) to the ultraviolet light source at 60 fpm and then evaluated. The tack free coating had an acetone double rub resistance of 100 (5). a pencil hardness of 6B, and a crosshatch adhesion rating of 5B.

Control Examples F and G and Example 44. These examples demonstrate that trimethylolpropane triacrylate does not polymerize when attempts are made to initiate polymerization with a hydrogen abstraction-type photosensitizer such as benzophenone (Control F) but does polymerize when a polymeric urea compound designed for use in the compositions of this invention is added to the formulation (Example 44) or when a photoinitiator of the homolytic fragmentation type is used to initiate polymerization (Control G). The following ingredients were placed in glass containers and well mixed. After the photosensitizer was dissolved, the compositions were drawn down into films on Bonderite 37 steel panels with a No. 15 wire-wound rod and exposed in an air atmosphere to the same ultraviolet light source that was used for Examples 39-43 at the indicated cure speeds and number of passes under the ultraviolet light source.

| Ingredients, g | Control F | Control G | Example 44 | |
|---|---|---|---|---|
| Polyurea III | --- | --- | 5.0 | |
| Trimethylolpropane triacrylate | 10.0 | 10.0 | 5.0 | |
| Benzophenone | 0.5 | --- | 0.5 | |
| Photoinitiator I | --- | 0.5 | --- | |
| **Cure Conditions** | | | | |
| Cure Speed, fpm | 20 | 20 | 20 | 20 |
| No. of Passes | 6 | 1 | 1 | 2 |
| **Test Results** | | | | |
| Double Acetone Rubs | Remained liquid, no polymerization took place | 100 (1) | 100 (5) | 100 (1) |
| Pencil Hardness | | 4H | 6B | B |
| Crosshatch Adhesion | | 0B | 5B | 5B |

Thus, addition of the polyurea to the composition of multi-functional acrylate and photosensitizer resulted in a system that polymerized when exposed to ultraviolet light and that had improved adhesion over the system that contained the was polymerized with Photosensitizer I.

Examples 45-54. These examples describe the fact that a variety of responses can be obtained from the compositions of this invention when different multi-functional polyureas are used in different quantities in the composition. The following ingredients were placed in glass containers and well mixed. After the photosensitizer was dissolved, the compositions were drawn down into films on Bonderite 37 steel panels with a No. 15 wire-wound rod and exposed in an air atmosphere to the same ultraviolet light source that was used for Examples 39-43 using one pass under the ultraviolet light source at a conveyor speed (cure speed) of 20 feet per minute. After exposure, the panels were tested in the previously described manner.

| Ingredients, g | EXAMPLE 45 | 46 | 47 |
|---|---|---|---|
| Polyurea IV | 4.00 | 6.00 | 10.00 |
| Trimethylolpropane Triacrylate | 8.00 | 7.00 | 5.00 |
| Epoxy Diacrylate I | 8.00 | 7.00 | 5.00 |
| Benzophenone | 1.00 | 1.00 | 1.00 |
| **Properties** | | | |
| Acetone Double Rubs | 100 (1) | 100 (1) | 100 (5) |
| Pencil Hardness | 2H | HB | <6B |
| Crosshatch Adhesion | 1B | 3B | 5B |

| Ingredients, g | EXAMPLE 48 | 49 | 50 |
|---|---|---|---|
| Example 37 Polyurea | 4.00 | 6.00 | 10.00 |
| Trimethylolpropane Triacrylate | 8.00 | 7.00 | 5.00 |
| Epoxy Diacrylate I | 8.00 | 7.00 | 5.00 |
| Benzophenone | 1.00 | 1.00 | 1.00 |
| **Properties** | | | |
| Acetone Double Rubs | 100 (1) | 100 (4) | 30 (5) |
| Pencil Hardness | H | 2B | <6B |
| Crosshatch Adhesion | 1B | 4B | 5B |

| Ingredients, g | EXAMPLE 51 | 52 | 53 |
|---|---|---|---|
| Example 38 Polyurea | 4.00 | 6.00 | 10.00 |
| Trimethylolpropane Triacrylate | 8.00 | 7.00 | 5.00 |
| Epoxy Diacrylate I | 8.00 | 7.00 | 5.00 |
| Benzophenone | 1.00 | 1.00 | 1.00 |
| **Properties** | | | |
| Acetone Double Rubs | 100 (1) | 100 (4) | 30 (5) |
| Pencil Hardness | 2H | B | <6B |
| Crosshatch Adhesion | 0B | 4B | 5B |

## Claims

1. A photocurable composition comprising:
   i) an aromatic ketone photosensitizer,
   ii) a multifunctional urea compound of the formula

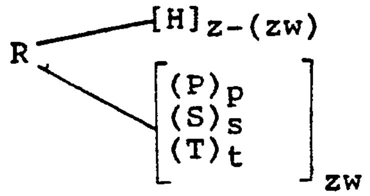

where R is an initiator radical based on a compound containing Zerewitinoff active hydrogen atoms and contains from two to six carbon atoms, H is a hydroxy-containing group of the formula:

$$-(CH_2CH_2-O)_a(CH_2\overset{CH_3}{CH}-O)_b(CH_2\overset{R'}{CH}-O)_{cd}-(CH_2)_n\overset{R''}{CH}-O(H)_{1-y}(I)_y,$$

P is a primary amine-containing group of the formula:

$$-(CH_2CH_2-O)_a(CH_2\overset{CH_3}{CH}-O)_b(CH_2\overset{R'}{CH}-O)_c-(CH_2)_n\overset{R''}{CH}-N(H)_{2-2u}(I)_{2u},$$

S is a secondary amine-containing group of the formula:

```
                  CH3              R'               R''R'''
                  /                /                /  /
-(CH2CH2-O)a(CH2CH-O)b(CH2CH-0)c-(CH2)nCH-N(H)1-u(I)u,
```

T is a tertiary amine-containing group of the formula:

```
                 CH3          R'             R''R''''
                 /            /              /  /
(CH2CH2-O)a(CH2CH-O)b(CH2CH-0)c-(CH2)nCH-NR''',
```

wherein a has a value of from zero to 175, b has a value of zero to 175, c has a value of zero to 30, n is an integer of from 1 to 3, y has a value of zero to u, u has a value of zero to 1.0, R' is an alkyl group of 2 to 18 carbons, R" is hydrogen or an alkyl group of one to 18 carbon atoms, R''' and R'''' are independently an alkyl group of 2 to 12 carbon atoms, I is a group represented by the formula:

```
-C-N-R5R6
 ||  /
 O  H
```

wherein $R^5$ is alkyl of one to 10 carbon atoms, alkylene of one to 6 carbon atoms, aryl, arylene, aralkyl, cycloalkyl, phenyl, substituted phenyl, phenylene, substituted phenylene and $R^6$ is hydrogen, alkyl of one to 10 carbon atoms, alkylene of one to 6 carbon atoms, aryl, aralkyl, cycloalkyl, allyl, alkyl or other substituted allyl, vinyl, and alkyl or other substituted vinyl, p is a mole fraction and ranges from zero to 1.0, s a mole fraction and ranges from zero to 1.0, t is a mole fraction and ranges from zero to 0.7, the quantity (p + s + t) equals one, w is the percent amination and ranges from 0.3 to 1.0, z is an integer from 2 to six and (zw) is the product of z and w, and
iii) an ethylenically unsaturated compounds that will undergo photopolymerization.

2. The photocurable composition of Claim 1 wherein a is from zero to 90, b is from zero to 115, c is from zero to 15, R' is an ethyl group, R" is hydrogen or a methyl or ethyl group, and R''' and R'''' contain from two to six carbon atoms.

3. The photocurable composition of Claim 2 wherein a is from zero to 50, b is from 3 to 98, c is from zero to 2, n is one.

4. The photocurable composition of Claim 1 wherein t is from zero to 0.2.

5. The photocurable composition of Claim 1 wherein a and c equal zero, b is 30 to 40, z equals 3, n equals one, and R" is methyl.

6. The photocurable composition of Claim 5 wherein p equals 0.65 to 1.0, s equals zero to 0.30, t equals zero to 0.05.

7. The photocurable composition of Claim 5 wherein p plus t equals zero to 0.30, s equals 0.70 to 1.0.

8. The photocurable composition of Claim 5 wherein R''' is isopropyl.

9. The photocurable composition of Claim 1 wherein R is $[0-(CH_2)_4]_d-0-(CH_2)_4-0-$wherein d is from 0 to 50, a, b, and c equal zero, z equals 2, n equals 3, and R" is hydrogen.

10. The photocurable composition of Claim 9 wherein d is from 4 to 35.

11. The photocurable composition of Claim 1 wherein the aromatic ketone photosensitizer is benzophenone.

12. The photocurable composition of Claim 1 wherein the aromatic ketone photosensitizer is a mixture of benzophenone and isopropylthioxanthone.

13. The photocurable composition of Claim 1 which also contains one or more photoinitiators of the homolytic fragmentation type.

14. The photocurable composition of Claim 13 wherein the photoinitiator is 1-hydroxycyclohexylphenyl ketone.

15. The photocurable composition of Claim 13 wherein the photoinitiator is 2,2-diethoxyacetophenone.

16. The photocurable composition of Claim 11 wherein the photocurable composition also contains 1-hydroxycyclohexylphenyl ketone as a photoinitiator.

17. The photocurable composition of Claim 1 wherein the ethylenically unsaturated compound is selected from the group consisting of monoacrylates, diacrylates, triacrylates and higher functionality acrylates.

18. The photocurable composition of Claim 17 wherein the acrylate is trimethylolpropane triacrylate.

19. The photocurable composition of Claim 17 wherein the acrylate is an urethane acrylate.

20. The photocurable composition of Claim 17 wherein the acrylate is an epoxy acrylate.

21. The photocurable composition of Claim 17 wherein the acrylate is a mixture of trimethylolpropane triacrylate and an epoxy acrylate.

22. The photocurable composition of Claim 17 wherein the acrylate is a mixture of trimethylolpropane triacrylate and an urethane acrylate.

23. The photocurable composition of Claim 1 wherein I is

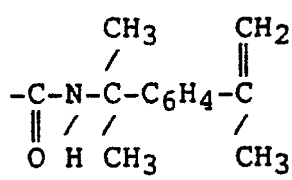

24. The photocurable composition of Claim 1 wherein I is

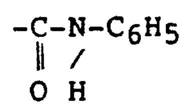

25. The photocurable composition of Claim 1 wherein I is

```
-C-N-CH2-CH2-CH2-CH3
 || /
 O H
```

26. A liquid photoinitiator composition which comprises from about one to about 75 percent by weight of an aromatic ketone photosensitizer and from about 25 to 99 percent by weight of a multifunctional urea compound of the formula:

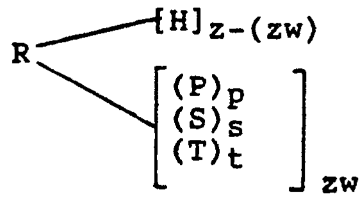

where R is an initiator radical based on a compound containing Zerewitinoff active hydrogen atoms and contains from two to six carbon atoms, H is a hydroxy-containing group of the formula:

```
          CH3              R'              R''
          /                /               /
-(CH2CH2-O)a(CH2CH-O)b(CH2CH-0)cd-(CH2)nCH-O(H)1-y(I)y,
```

P is a primary amine-containing group of the formula:

```
          CH3              R'              R''
          /                /               /
-(CH2CH2-O)a(CH2CH-O)b(CH2CH-0)c-(CH2)nCH-N(H)2-2u(I)2u,
```

S is a secondary amine-containing group of the formula:

```
          CH3              R'              R''R'''
          /                /               /  /
-(CH2CH2-O)a(CH2CH-O)b(CH2CH-0)c-(CH2)nCH-N(H)1-u(I)u,
```

T is a tertiary amine-containing group of the formula:

```
          CH3              R'              R''R''''
          /                /               /  /
(CH2CH2-O)a(CH2CH-O)b(CH2CH-0)c-(CH2)nCH-NR''',
```

wherein a has a value of from zero to 175, b has a value of zero to 175, c has a value of zero to 30, n is an integer of from 1 to 3, R' is an alkyl group of 2 to 18 carbons, R" is hydrogen or an alkyl group of one to 18 carbon atoms, R"' and R"" are independently an alkyl group of 2 to 12 carbon atoms, p is a mole fraction and ranges from zero to 1.0, s is a mole fraction and ranges from zero to 1.0, t is a mole fraction and ranges from zero to 1.0, the quantity (p + s + t) equals one, w is the percent amination and ranges from 0.3 to 1.0 z is an integer from 2 to six and (zw) is the product of z and w.

27. The photoinitiator composition of Claim 26 wherein a is from zero to 90, b is from zero to 115, c is from

zero to 15, R' is an ethyl group, R" is hydrogen or a methyl or ethyl group, and R''' and R'''' contain from two to six carbon atoms.

**28.** The photoinitiator composition of Claim 26 wherein a is from zero to 50, b is from 3 to 98, c is from zero to 2, n is one.

**29.** The photoinitiator composition of Claim 26 wherein t is from zero to 0.2.

**30.** The photoinitiator composition of Claim 26 wherein a and c equal zero, b is 30 to 40, z equals 3, n equals one, and R" is methyl.

**31.** The photoinitiator composition of Claim 30 wherein p equals 0.65 to 1.0, s equals zero to 0.30, t equals zero to 0.05.

**32.** The photoinitiator composition of Claim 30 wherein p plus t equals zero to 0.30, s equals 0.70 to 1.0.

**33.** The photoinitiator composition of Claims 30 wherein R''' is isopropyl.

**34.** The photoinitiator composition of Claim 26 wherein R is $[O-(CH_2)_4]_d-O-(CH_2)_4-O-$wherein d is from 0 to 50, a, b, and c equal zero, z equals 2, n equals 3, and R" is hydrogen.

**35.** The photoinitiator composition of Claim 34 wherein d is from 4 to 35.

**36.** The photoinitiator composition of Claim 26 wherein the aromatic ketone photosensitizer is benzophenone.

**37.** The photoinitiator composition of Claim 26 wherein the aromatic ketone photosensitizer is a mixture of benzophenone and isopropylthioxanthone.

**38.** The photoinitiator composition of Claim 26 which also contains one or more photoinitiators of the homolytic fragmentation type.

**39.** The photoinitiator composition of Claim 38 wherein the photoinitiator is 1-hydroxycyclohexylphenyl ketone.

**40.** The photoinitiator composition of Claim 38 wherein the photoinitiator is 2,2-diethoxyacetophenone.

**41.** The photoinitiator composition of Claim 36 wherein the photocurable composition also contains 1-hydroxycyclohexylphenyl ketone as a photoinitiator.

**42.** The photocurable composition of claim 26 wherein I is

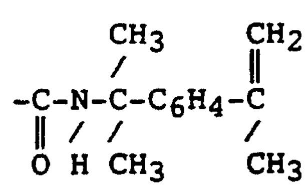

**43.** The photocurable composition of claim 26 wherein I is

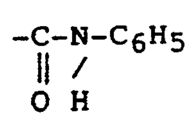

**44.** The photocurable composition of claim 26 wherein I is

$$-\underset{\underset{O}{\|}}{C}-\underset{\underset{H}{/}}{N}-CH_2-CH_2-CH_2-CH_3$$

**45.** A process for preparing a photocured product comprising:

(1) mixing until homogeneous a photocurable composition of Claim 1, and

(2) exposing the photocurable composition to ultraviolet light for a sufficient length of time to cure the composition.

**46.** The cured product of Claim 45.